# EUROPEAN PATENT SPECIFICATION

(11) **EP 1 605 009 B1**
(45) Date of publication and mention of the grant of the patent: **01.08.2007**
(21) Application number: 05012426.2
(22) Date of filing: 09.06.2005
(51) Int. Cl.: C08G 73/06, C08G 73/12, C08F 22/40, B32B 7/04

(54) **Curable resin composition and its use**
Zusammensetzung eines härtbaren Harzes und seine Verwendung
Composition de résine durcissable et son utilisation

(30) Priority: 09.06.2004 JP 2004171495; 26.04.2005 JP 2005127660
(43) Date of publication of application: 14.12.2005
(73) Proprietor: MITSUBISHI GAS CHEMICAL COMPANY, INC., Chiyoda-ku, Tokyo (JP)
(72) Inventor: Nozaki, Mitsuru, 1-1, Niijuku 6-chome Katsushika-ku Tokyo (JP)
(74) Representative: Albrecht, Thomas

(56) References cited:
- US-A- 4 389 516
- US-A- 5 789 757
- US-B1- 6 281 314

## Description

### Field of the Invention

The present invention relates to a cyanate ester type resin composition improved in resistance to crack. The resin composition obtained is suitably used for applications such as a material for a printed wiring board, a structural material and a casting resin.

### Description of Prior Arts

Cyanate ester resins have been widely known as a thermosetting resin having high heat resistance and excellent dielectric characteristics. As a resin composition thereof, there are disclosed cases (see, for example, JP-B-54-30440) where a thermosetting resin such as an epoxy rein or a bismaleimide compound or a thermoplastic resin such as polyphenylene ether is used in combination with the cyanate ester resin. In recent years, the cyanate ester resins are widely used for a material for a high-function printed wiring board such as a semiconductor plastic package on the basis of the above technologies. These cyanate ester type resin compositions have excellent properties in terms of electric characteristics, mechanical characteristics, chemical resistance, adhesiveness, etc. However, these cyanate ester type resin compositions tend to have a high elastic modulus peculiar to high heat-resistant thermosetting resins so that resin cracks easily occur with regard to a res in composition having no reinforcing base material or under severe conditions. Therefore, these cyanate ester type resin compositions are susceptible to improvement in regard to resistance to crack. As a means for improving the resistance to crack of cyanate ester type resins, resin compositions containing polybutadiene, acrylic rubber, a phenol modified petroleum resin, a monomaleimide compound, etc., are proposed (JP-B-63-35664, JP-B-63-26147, JP-A-5-287167 and JP-A-6-345864). However, with regard to some of these proposed means, a considerable decrease in heat resistance is not avoidable for satisfying resistance to crack. Further, most of these means are insufficient in the improvement effect of resistance to crack. These proposed means are limited in practical uses and further improvement is required.

### Summary of the Invention

It is an object of the present invention to provide a cyanate ester type resin composition which is improved in resistance to crack.

It is another object of the present invention to provide a resin composition having low elasticity and high heat resistance.

The present invention provides a resin composition containing a cyanate ester resin (a) having at least two cyanate groups per molecule and a bismaleimide compound (b) represented by the formula (1), 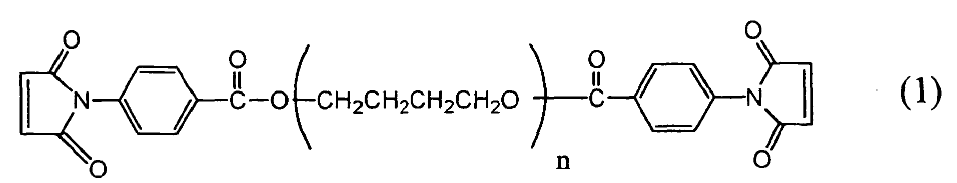 wherein n is an average value and is in the range of from 1 to 30.

The present invention further provides a resin composition according to the above, wherein the amount of the bismaleimide compound (b) per 100 parts by weight of the cyanate ester resin (a) is 5 to 200 parts by weight.

The present invention still further provides a copper-clad laminate using the above resin composition and a printed wiring board using the above copper-clad laminate.

### Detailed Description of the Invention

The present inventors have made diligent studies for overcoming the above object and as a result found that a cured product obtained from a resin composition obtained by incorporating a specific bismaleimide compound into a cyanate ester resin is excellent in resistance to crack and has high heat resistance. On the basis of the above finding, the present inventors have arrived at the present invention.

The cyanate ester resin (a) used in the present invention is not specially limited so long as it is a compound having at least two cyanate groups per molecule. Specific examples thereof include 1,3- or 1,4-dicyanatobenzene, 1,3,5-tricyanatobenzene, 1,3-, 1,4-, 1,6-, 1,8-, 2,6- or 2,7-dicyanatonaphthalene, 1,3,6-tricyanatonaphthalene, 4,4-dicyanatobiphenyl, bis(4-cyanatophenyl)methane, bis(3,5-dimethyl-4-cyanatophenyl)methane, 2,2-bis(4-cyanatophenyl)propane, 2,2-bis(3,5-dibromo-4-cyanatophenyl)propane, 2,2-bis(3,5-dimethyl-4-cyanatophenyl)propane, bis(4-cyanatophenyl)ether, bis(4-cyanatophenyl)thioether, bis(4-cyanatophenyl)sulfone, tris(4-cyanatophenyl)phosphite, tris(4-cyanatophenyl)phosphate, cyanate esters obtained by a reaction of an oligomer, etc., of novolak or a hydroxyl-group-containing thermoplastic resin, such as hydroxypolyphenylene ether, hydroxypolystyrene, hydroxypolycarbonate, etc., with a cyanogen halide, a cyanate ester (Japanese Kohyo No. 61-501094) obtained by a reaction of a polyfunctional phenol having phenols bonded with dicyclopentadiene with a cyanogen halide, and cyanate esters disclosed in JP-B-41-1928, JP-B-43-18468, JP-B-44-4791, JP-B-45-11712, JP-B-46-41112, JP-B-47-26853and JP-A-51-63149, etc. These cyanate ester resins may be used alone or in combination, as required.

The cyanate ester resin (a) is preferably 1,3- or 1,4-dicyanatobenzene, 1,3,5-tricyanatobenzene, bis(3,5-dimethyl-4-cyanatophenyl)methane, bis(4-cyanatophenyl)methane, 2,2-bis(4-cyanatophenyl)propane or phenol novolak cyanate. Further, prepolymers having a triazine ring formed by trimerization of cyanate groups of any one of these cyanate esters and having a molecular weight of 400 to 6, 000 are suitably used. The above prepolymer is obtained by polymerizing the above cyanate ester monomer in the presence of an acid such as a mineral acid or a Lewis acid; a base such as sodium alcoholate or a tertiary amine; or a salt such as sodium carbonate as a catalyst.

The bismaleimide compound (b) used in the present invention refers to a bismaleimide compound {polytetramethyleneoxide-bis(4-maleimidobenzoate)} represented by the aforementioned formula (1) . The bismaleimide compound (b) may be used alone or at least two bismaleimide compounds (b) which are different from each other with regard to n in the formula (1) may be mixed and used as required. The bismaleimide compound (b) of the formula (1) is obtained by reacting a diamino compound {polytetramethyleneoxide-bis(4-aminobenzoate)} represented by the following formula (2) with maleic anhydride. Since the above diamino compound generally has a molecular weight distribution derived from polytetramethylene glycol as a raw material, the bismaleimide compound (b) of the formula (1) contains two or more kinds of bismaleimide compounds having different molecular weights in most cases. 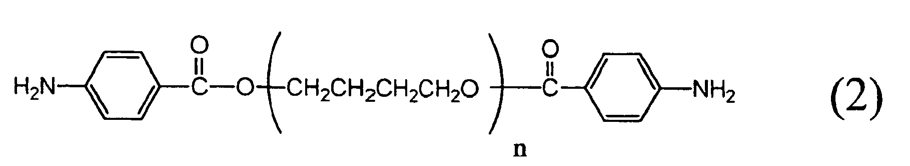 (wherein n is an average value and is in the range of from 1 to 30.)

The bismaleimide compound (b) is preferably a bismaleimide compound having n of the formula (1) in the range of from 3 to 21, more preferably in the range of from 7 to 18. The amount of the bismaleimide compound (b) based on the cyanate ester resin (a) is not specially limited. The amount of the bismaleimide compound (b) per 100 parts by weight of the cyanate ester resin (a) is preferably 5 to 200 parts by weight, more preferably 10 to 120 parts by weight.

In the present invention, the method for preparing the resin composition containing the cyanate ester resin (a) and the bismaleimide compound (b) is not specially limited. For example, the cyanate ester resin (a) and the bismaleimide compound (b) may be simply melt-blended or may be mixed after dissolving the cyanate ester resin (a) and the bismaleimide compound (b) in an organic solvent such as methyl ethyl ketone, N-methyl pyrolidone, dimethylformamide, dimethylacetamide, toluene or xylene. Further, the cyanate ester resin (a) and the bismaleimide compound (b) may be mixed after converting one or both of the cyanate ester resin (a) and the bismaleimide compound (b) into oligomer(s). Moreover, it is possible to convert the cyanate ester resin (a) and the bismaleimide compound (b) into oligomers after mixing both of them.

The resin composition of the present invention preferably contains an epoxy resin. The epoxy resin can be selected from known epoxy resins. Concrete examples thereof include a bisphenol A type epoxy resin, a bisphenol F type epoxy resin, a phenol novolak type epoxy resin, a cresol novolak type epoxy resin, a bisphenol A novolak type epoxy resin, a trifunctional or tetrafunctional phenol type epoxy resin, a naphthalene type epoxy resin, a biphenyl type epoxy resin, a phenol aralkyl type epoxy resin, a biphenyl aralkyl type epoxy resin, a naphthol aralkyl type epoxy resin, and nuclear brominated epoxy resins of these epoxy resins; phosphorus-containing epoxy resins obtained by a reaction of a phosphorus-containing compound with an epoxy resin or epichlorohydrin; an alicyclic epoxy resin, a polyol type epoxy resin, glycidyl amine, glycidyl ester; compounds obtained by epoxidation of a double bond such as butadiene; and compounds obtained by a reaction of a hydroxyl-group-containing silicon resin with epichlorohydrin. These epoxy resins may be used alone or in combination, as required.

Further, the resin composition of the present invention may contain a known bismaleimide compound other than the bismaleimide compound of the formula (1) . Concrete examples thereof include bis(4-maleimidophenyl)methane, 2,2-bis{4-(4-maleimidophenoxy)-phenyl}propane, bis(3,5-dimethyl-4-maleimidophenyl)methane, bis(3-ethyl-5-methyl-4-maleimidophenyl)methane, bis(3,5-diethyl-4-maleimidophenyl)methane, prepolymers of these bismaleimide compounds, and prepolymers of bismaleimide compound and an amine compound. These bismaleimide compounds other than the bismaleimide compound of the formula (1) may be used alone or in combination, as required.

The resin composition of the present invention undergoes curing itself under heat, while a known curing catalyst or a known curing accelerator may be incorporated for the purpose of accelerating the curing. Examples of such compounds include organic peroxides such as benzoyl peroxide, lauroyl peroxide, acetyl peroxide, parachlorobenzoyl peroxide and di-tert-butyl-di-perphthalate; azo compounds such as azobisnitrile; imidazoles such as 2-methylimidazole, 2-undecylimidazole, 2-phenylimidazole, 2-ethyl-4-methylimidazole, 1-benzyl-methylimidazole, 1-cyanoethyl-2-methylimidazole, 1-cyanoethyl-2-ethylimidazole, 1-cyanoethyl-2-undecylimidazole, 1-cyanoethyl-2-phenylimidazole, 1-cyanoethyl-2-ethyl-methylimidazole, 1-guanaminoethyl-2-methylimidazole, carboxylic acid adducts of these imidazoles and carboxylic anhydride adducts of these imidazoles; tertiary amines such as N,N-dimethylbenzylamine, N,N-dimethylaniline, N,N-dimethyltoluidine, 2-N-ethylanilinoethanol, tri-n-butylamine, pyridine, quinoline, N-methylmorpholine, triethanolamine, triethylenediamine, tetramethylbutanediamine and N-methylpiperidine; phenols such as phenol, xylenol, cresol, resorcin and catechol; organic metal salts such as lead naphthenate, lead stearate, zinc naphthenate, zinc octylate, tin oleate, dibutyltin maleate, manganese naphthenate, cobalt naphthenate and acetylacetone iron; materials obtained by dissolving any one of these organic metals in a hydroxyl-group-containing compound such as phenol or bisphenol; inorganic metal salts such as tin chloride, zinc chloride and aluminum chloride; organotin compounds such as dioctyltin oxide, other alkyltin and alkyltin oxide; acid anhydrides such as maleic anhydride, phthalic anhydride, anhydrous lauril acid, pyromellitic anhydride, trimellitic anhydride, hexahydrophthalic anhydride, hexahydrotrimellitic anhydride, and hexahydropyromellitic anhydride. These compounds may be used alone or in combination, as required. The curing catalyst or the curing accelerator may be added in a general amount. For example, the amount of the curing catalyst or the curing accelerator based on the resin composition is 10 wt% or less, generally about 0.01 to 2 wt%.

The resin composition of the present invention may contain a variety of additives so long as the inherent properties of the resin composition are not impaired. These additives include natural or synthetic resins, an inorganic or organic fibrous reinforcing material or an inorganic or organic filler. These additives may be properly used in combination, as required. Examples of the natural or synthetic resins include polyimide; polyvinyl acetal; a phenoxy resin; an acrylic resin; an acrylic resin having a hydroxyl group or a carboxylic group; a silicon resin; an alkyd resin, a thermoplastic polyurethane resin; polybutadiene, a butadiene-acrylonitrile copolymer; elastomers such as polychloroprene, a butadiene-styrene copolymer, polyisoprene, butyl rubber, fluoro rubber and natural rubber; styrene-isoprene rubber, acrylic rubber, core shell rubbers of these; epoxidized butadiene, maleated butadiene; vinyl compound polymers such as polyethylene, polypropylene, a polyethylene-propylene copolymer, poly-4-methylpentene-1, polyvinyl chloride, polyvinylidene chloride, polystyrene, polyvinyl toluene, polyvinyl phenol, AS resin, ABS resin, MBS resin, poly-4-fluoroethylene, a fluoroethylene-propylene copolymer, 4-fluoroethylene-6-fluoroethylene copolymer and vinylidene fluoride; thermoplastic resins such as polycarbonate, polyester carbonate, polyphenylene ether, polysulfone, polyester, polyether sulfone, polyamide, polyamide imide, polyester imide and polyphenylene sulfite, and low-molecular-weight polymers thereof; poly(meth)acrylates such as (meth)acrylate, epoxy(meth)acrylate and di(meth)acryloxy-bisphenol; polyallyl compounds such as styrene, vinylpyrrolidone, diacrylphthalate, divinylbenzene, diallyl benzene, diallyl ether bisphenol and trialkenyl isocyanurate, and prepolymers thereof; dicyclopentadiene and prepolymers thereof; a phenol resin; monomers containing a polymerizable double bond such as an unsaturated polyester, and prepolymers thereof; curable monomers or prepolymers such as polyisocyanates.

Examples of the inorganic or organic fibrous reinforcing material include inorganic fibers such as glass fibers typified by E, NE, D, S and T glasses, a silica glass fiber, a carbon fiber, an alumina fiber, a silicon carbide fiber, asbestos, rockwool, slagwool andplasterwhisker, woven fabrics or non-woven fabrics thereof, or mixtures of these; organic fibers such as a wholly aromatic polyamide fiber, a polyimide fiber, a liquid crystal polyester, a polyester fiber, a fluorine fiber, a polyoxazole fiber, cotton, linen and a semi-carbon fiber, woven fabrics or non-woven fabrics thereof, or mixtures of these; combined woven fabrics such as a glass fiber with a wholly polyamide fiber, a glass fiber with a carbon fiber, a glass fiber with a polyamide fiber, and a glass fiber with a liquid crystal aromatic polyester; inorganic papers such as glass paper, mica paper and alumina paper; kraft paper, cotton paper, paper-glass combined paper, etc., and mixed fibrous reinforcing materials properly composed of at least two members of the above materials. These materials are preferably subjected to a known surface-treatment for improving the adhesion to a resin. Further, a film base material such as a polyimide film, a wholly aromatic polyamide film, a polyoxazole film or a liquid crystal polyester film may be used for a thin material.

Examples of the inorganic or organic filler include silica, fused silica, synthesized silica, spherical silica, talc, calcinedtalc, kaolin, wollastonite, aluminum hydroxide, non-alkali glass, molten glass, silicon carbide, alumina, aluminumnitride, silica alumina, boronnitride, titanium oxide, wollastonite, mica, synthesized mica, plaster, calcium carbonate, magnesium carbonate, magnesium hydroxide and magnesium oxide. These fillers can be properly used in combination, as required. Further, various additives such as a dye, a pigment, a thickener, a lubricant, an antifoamer, a dispersing agent, a leveling agent, a photosensitizer, a flame retardant, a brightener, a polymerization inhibitor and a thixotropic agent may be used alone or in combination as required.

The curing condition for the resin composition of the present invention varies depending on the constituents or constituent ratio of the resin composition, the presence or absence of the curing catalyst or curing accelerator, etc. For gelation or preliminary curing, it is possible to use a temperature of 100 °C or lower by selecting the curing catalyst or curing accelerator. However, for complete curing, the resin composition of the present invention is heated at a temperature properly selected in the range of generally 100 °C to 300 °C for a predetermined period of time, to obtain a cured product. In this case, the pressure level is not specially limited, while it is generally preferable to apply a pressure. Generally, the pressure is properly selected in the range of 0.01 to 50 MPa. The resin composition of the present invention is used for various applications owing to its excellent physical properties and workability. For example, it is suitably used for a material for a printed wiring board such as prepreg or a copper-clad laminate, a structural material and a casting resin.

### Effect of the Invention

The cured product obtained from the cyanate ester type resin composition containing the specific bismaleimide compound, provided by the present invention, is excellent in resistance to crack and has low elasticity and high heat resistance. The above resin composition is an epoch-making resin composition which overcomes the disadvantages of a conventional high-heat-resistant thermosetting resin composition. Therefore, it has great industrial significance.

### Examples

The present invention will be concretely explained with reference to Examples and Comparative Examples hereinafter, in which "part" stands for "part by weight".

### (Examples 1 to 4)

A prepolymer of 2,2-bis(4-cyanatophenyl)propane (BT2160RX, Mitsubishi Gas Chemical Company, Inc.), a bismaleimide compound of the formula (1) wherein n was about 14 (BMI-1000P, K I KASEI KK), a bismaleimide compound of the formula (1) wherein n was about 9 (BMI-650P, K I KASEI KK), abisphenolAtype epoxy resin (Epikote 828EL, JapanEpoxyResins Co., Ltd.) were incorporated as shown in Table 1, and melt-blended at 150 °C for 20 minutes. The melt-blended mixture was poured into a mold for casting, degassed under vacuum at 150 °C for 15 minutes, then cured under heat at 180 °c for 4 hours and further cured under heat at 250 °C for 4 hours, to obtain two kinds of cured products, one of which had a thickness of 4 mm and the other of which had a thickness of 20 mm. The thus-obtained cured products were cut and polished to prepare samples having a predetermined size for respective measurements. The samples were measured for a glass transition temperature, a bending strength, a bend elastic constant and resistance to crack. Table 1 shows the results thereof.

### (Comparative Examples 1 to 4)

A prepolymer of 2,2-bis(4-cyanatophenyl)propane (BT2160RX), bis(4-maleimidophenyl)methane (BMI-1000, Daiwakasei Industry Co., Ltd.) and polybutadiene (E-1800-6. 5, NIPPON PETROCHEMICALS COMPANY, LIMITED) were incorporated as shown in Table 2 and melt-blended at 150 °C for 20 minutes. The resultant mixture was cured under heat under the conditions similar to those of Example 1, to obtain two kinds of cured products, one of which had a thickness of 4 mm and the other of which had a thickness of 20 mm. The thus-obtained cured products were measured similarly to Example 1. Table 2 shows the results thereof.

**Table 1**

| | Example 1 | Example 2 | Example 3 | Example 4 |
|---|---|---|---|---|
| BT2160RX (part) | 90 | 50 | 50 | 40 |
| BMI-1000P (part) | 10 | 50 | - | 40 |
| BMI650P (part) | - | - | 50 | - |
| Epikote 828 EL (part) | - | - | - | 20 |
| Glass transition temperature (°C) | 251 | 267 | 265 | 242 |
| Bend elastic constant (MPa) | 2,059 | 1,177 | 1,140 | 1,053 |
| Bending strength (MPa) | 111 | 98 | 94 | 97 |
| Resistance to crack | 0/3 | 0/3 | 0/3 | 0/3 |

**Table 2**

| | Comparative Example 1 | Comparative Example 2 | Comparative Example 3 | Comparative Example 4 |
|---|---|---|---|---|
| BT2160RX (part) | 90 | 50 | 100 | 50 |
| BMI-1000 (part) | 10 | 50 | - | - |
| E-1800-6.5 (part) | - | - | - | 50 |
| Glass transition temperature (°C) | 230 | 206 | 210 | 153 |
| Bend elastic constant (MPa) | 7,845 | 6,080 | 7,354 | 1,520 |
| Bending strength (MPa) | 93 | 45 | 89 | 67 |
| Resistance to crack | 3/3 | 3/3 | 3/3 | 0/3 |

### (Example 5)

50 parts of 2,2-bis(4-cyanatophenyl)propane (CX, Mitsubishi Gas Chemical Company, Inc.) and 50 parts of a bismaleimide of the formula (1) wherein n was about 14 (BMI-1000P) were mixed and the mixture was molten and reacted under heat at 160 °C for 5 hours, to obtain an oligomer resin composition. 100 parts of the thus-obtained resin composition was dissolved in methyl ethyl ketone. Then 0.05 part of zinc octylate was dissolved and mixed in the resultant solution, to obtain a varnish having a resin solid content of 60 %. The above varnish was impregnated into a plain-weave E glass woven fabric (116H, Nitto Boseki Co., Ltd.) having a thickness of 0.1 mm and then dried at 150 °C for 6 minutes to obtain prepregs having a resin content of 4 5 wt%. Four said prepregs were stacked, electrolytic copper foils (3EC foil, Mitsui Mining and Smelting Co., Ltd.) having a thickness of 18 µm each were placed on the upper and lower surfaces of the stacked prepregs, one on one surface and the other on the other surface, and the resultant set was laminate-formed at 200 °C at a pressure of 30kg/cm² for 120 minutes, to obtain a copper-clad laminate having a thickness of 0.4 mm. The thus-obtained copper-clad laminate was cut to prepare samples having a predetermined size for respective measurements. The samples were measured for a copper foil adhesive strength, a glass transition temperature, a moisture absorption heat resistance, and a soldering heat resistance. Table 3 shows the results thereof.

### (Example 6)

90 parts of 2, 2-bis(4-cyanatophenyl) propane (CX) and 10 parts of a bismaleimide compound of the formula (1) wherein n was about 14 (BMI-1000P) were mixed and the mixture was molten and reacted under heat at 160 °C for 5 hours, to obtain an oligomer resin composition. 50 parts of the thus-obtained resin composition was dissolved in methyl ethyl ketone. Then, 50 parts of a bisphenol A type epoxy resin (Epikote 1001, Japan Epoxy Resins Co., Ltd.) and 0.05 part of zinc octylate were dissolved and mixed in the resultant solution, to obtain a varnish having a resin solid content of 60 %. The above varnish was used, and a copper-clad laminate having a thickness of 0.4 mm was obtained in the same manner as in Example 5. Table 3 shows the measurement results of the physical properties of the copper-clad laminate.

### (Example 7)

50 parts of the same oligomer resin composition as that obtained in Example 5 was dissolved in methyl ethyl ketone. Then, 50 parts of a bisphenol A type epoxy resin (Epikote 1001) and 0.05 part of zinc octylate were dissolved and mixed in the resultant solution, to obtain a varnish having a resin solid content of 60 %. The above varnish was used, and a copper-clad laminate having a thickness of 0.4 mm was obtained in the same manner as in Example 5. Table 3 shows the measurement results of the physical properties of the copper-clad laminate.

### (Comparative Example 5)

50 parts of 2, 2-bis(4-cyanatophenyl)propane (CX) and 50 parts of bis(4-maleimidophenyl)methane (BMI-1000) were mixed and the mixture was molten and reacted under heat at 160 °C for 5 hours, to obtain an oligomer resin composition. 50 parts of the thus-obtained resin composition was dissolved in methyl ethyl ketone/dimethylformamide (1/1 mixed solvent). Then, 50 parts of a bisphenol A type epoxy resin (Epikote 1001) and 0.05 part of zinc octylate were dissolved and mixed in the resultant solution, to obtain a varnish having a resin solid content of 60 %. The above varnish was used, and a copper-clad laminate having a thickness of 0.4 mm was obtained in the same manner as in Example 5. Table 3 shows the measurement results of the physical properties of the copper-clad laminate.

**Table 3**

| | | Example 5 | | | Example 6 | | | Example 7 | | | Example 8 | | |
|---|---|---|---|---|---|---|---|---|---|---|---|---|---|
| Copper foil adhesive strength (kg/cm) | | 1.3 | | | 1.2 | | | 1.2 | | | 0.9 | | |
| Glass transition temperature (°C) | | 227 | | | 208 | | | 224 | | | 186 | | |
| Moisture absorption heat resistance | 2hours | ○ | ○ | ○ | ○ | ○ | ○ | ○ | ○ | ○ | ○ | ○ | ○ |
| | 4hours | ○ | ○ | ○ | ○ | ○ | ○ | ○ | ○ | ○ | ○ | ○ | ○ |
| | 6hours | ○ | ○ | ○ | ○ | ○ | ○ | ○ | ○ | ○ | × | × | ○ |
| Soldering heat resistance | | ○ | ○ | ○ | ○ | ○ | ○ | ○ | ○ | ○ | ○ | ○ | ○ |

### (Measurement methods)

### 1) Glass transition temperature:

A sample (cured product) having a size of 4mm x 4mm x 4mm or a sample (laminate) having a size of 4 mm x 4 mm x 0.4 mm was measured with a TMA apparatus (TA Instrumen type 2940) under a loading of 5 g and a temperature-increasing rate of 5 °C/min. The measurement was carried out three times, to obtain an average value.

### 2) Bending strength and Bend elastic constant:

A sample having a size of 10 mm x 80 mm x 4 mm was measured with an autograph apparatus (S-500 supplied by Shimadzu Corporation.) at a temperature of 25°C according to JIS 7203. The measurement was carried out five times, to obtain an average value.

### 3) Resistance to crack:

A sample having a size of 20 mm x 20 mm x 100 mm was heated in a heating furnace at 250 °C for 30 minutes and then immersed in cold water having a temperature of 5 °C for 5 minutes. The sample was checked for the presence or absence of a resin crack by visual observation (n/3 in Tables refers to number of cracks/number of measurement).

### 4) Copper foil adhesive strength:

Measured three times according to JIS C6481, to obtain an average value.

### 5) Moisture absorption heat resistance:

The entire copper foil of a 50 mm x 50 mm square sample other than a copper foil on the half of one surface of the sample was removed by etching. The sample was treated with a pressure cooker testing machine (PC-3 type, supplied by Hirayama Manufacturing Corporation) at 121 °C at 2 atmospheric pressure for a predetermined time, and then the sample was allowed to float in a solder bath at 260 °C for 60 seconds in accordance with JIS C6481, to check the presence or absence of failure of appearance change by visual observation. The number of samples: 3 (○: no change, ×: swelling or peeling occurred).

### 6) Soldering heat resistance:

A sample was allowed to float in a solder bath at a solder bath temperature of 260 °C for 60 seconds in accordance with JIS C6481, to check the presence or absence of failure of appearance change by visual observation. The number of samples: 3 (○: no change, ×: swelling or peeling occurred).

## Claims

1. A resin composition containing a cyanate ester resin (a) having at least two cyanate groups per molecule and a bismaleimide compound (b) represented by the formula (1), 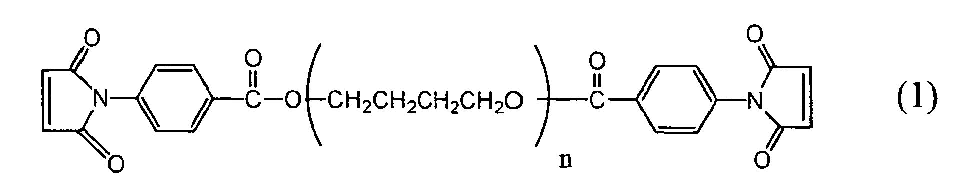 wherein n is an average value and is in the range of from 1 to 30.

2. A resin composition according to claim 1, wherein the amount of the bismaleimide compound (b) per 100 parts by weight of the cyanate ester resin (a) is 5 to 200 parts by weight.

3. A resin composition according to claim 1, which further contains an epoxy resin.

4. A resin composition according to claim 1, which further contains a curing catalyst or a curing accelerator.

5. A copper-clad laminate using the resin composition recited in claim 1.

6. A printed wiring board using the copper-clad laminate recited in claim 5.

## Patentansprüche

1. Harzzusammensetzung, enthaltend ein Cyanatesterharz (a) mit mindestens zwei Cyanatgruppen pro Molekül und eine Bismaleimidverbindung (b), die durch die Formel (1) dargestellt wird 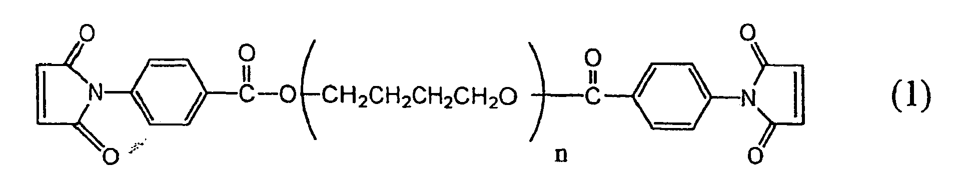 worin n ein Durchschnittswert ist und im Bereich von 1 bis 30 liegt.

2. Harzzusammensetzung gemäß Anspruch 1, wobei die Menge der Bismaleimidverbindung (b) pro 100 Gewichtsteile des Cyanatesterharzes (a) 5 bis 200 Gewichtsteile beträgt.

3. Harzzusammensetzung gemäß Anspruch 1, die des Weiteren ein Epoxyharz enthält.

4. Harzzusammensetzung gemäß Anspruch 1, die des Weiteren einen Härtungskatalysator oder einen Härtungsbeschleuniger enthält.

5. Kupferkaschiertes Laminat, das die Harzzusammensetzung gemäß Anspruch 1 verwendet.

6. Leiterplatte, die das kupferkaschierte Laminat gemäß Anspruch 5 verwendet.

## Revendications

1. Une composition de résine contenant une résine d'ester cyanique
(a) comportant au moins deux groupes cyaniques par molécule et un dérivé bismaléimide (b) représenté par la formule (1), 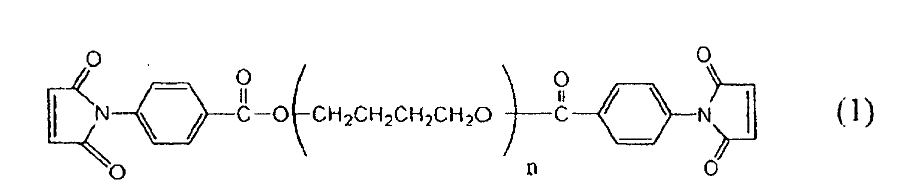 où n est une valeur moyenne et se situe dans la fourchette de 1 à 30.

2. Une composition de résine selon la revendication 1, dans laquelle la quantité de dérivé bismaléimide (b) pour 100 parties en poids de résine d'ester cyanique (a) est de 5 à 200 parties en poids.

3. Une composition de résine selon la revendication 1, qui renferme en outre une résine époxy.

4. Une composition de résine selon la revendication 1, qui renferme en outre un catalyseur de durcissement ou un accélérateur de durcissement.

5. Un stratifié de cuivre enrobé utilisant la composition de résine selon la revendication 1.

6. Un panneau de circuit imprimé utilisant le stratifié de cuivre enrobé selon la revendication 5.
